# EUROPEAN PATENT APPLICATION

(11) **EP 2 854 270 A1**
(43) Date of publication of application: **01.04.2015**
(21) Application number: 14159250.1
(22) Date of filing: 12.03.2014
(51) Int. Cl.: H02M 1/32, H02H 9/00, H02M 7/08, H05B 33/08

(54) **Rectifying circuit, electronic circuit, and electronic apparatus**

(30) Priority: 25.09.2013 JP 2013198923
(71) Applicant: Toshiba Lighting & Technology Corporation, Yokosuka-shi Kanagawa 237-8510 (JP)
(72) Inventor: Otake, Hirokazu, Kanagawa, 237-8510 (JP); Kitamura, Noriyuki, Kanagawa, 237-8510 (JP); Takahashi, Yuji, Kanagawa, 237-8510 (JP); Ishikawa, Masato, Kanagawa, 237-8510 (JP); Miura, Yohei, Kanagawa, 237-8510 (JP)
(74) Representative: Willquist, Sofia Ellinor

(57) **Abstract**

A rectifying circuit (1, 4, 8, 21) according to an embodiment includes a first rectifying portion (2, 5) and a second rectifying portion. The first rectifying portion has a positive temperature coefficient. The second rectifying portion (3) has a negative temperature coefficient, is connected in parallel to the first rectifying portion (2, 5), and has a forward voltage-forward current curve intersecting a forward voltage-forward current curve of the first rectifying portion (2, 5).

## Description

### FIELD

Embodiments described herein relate generally to a rectifying circuit, an electronic circuit, and an electronic apparatus.

### BACKGROUND

It is desirable that rectifying circuits such as high breakdown voltage diodes used in a power source apparatus and the like have a low loss. In addition, for example, the diodes are required to have resistance to superimposed lightning surge currents in a power source apparatus connected to an AC power supply line. Elements made of a wide band gap compound semiconductor attract attention as such diodes. Among them, a diode (hereinafter, referred to as a GaN diode) formed using a nitride semiconductor such as GaN has a high saturation electron speed, and is currently being put into practical use as a high-speed device.

In the GaN diode, a forward voltage has a positive temperature coefficient with respect to a temperature. Under room temperature circumstances, the GaN diode has a forward voltage lower than a silicon diode and thus operates at a low loss, but, in a high temperature region, the GaN diode has a conduction loss greater than that of the silicon diode which has a negative temperature coefficient. In addition, the GaN diode has a forward voltage lower than that of the silicon diode in a small current region. However, in a large current region, the silicon diode showing an exponential current-voltage characteristic has a lower forward voltage, and the GaN diode has a greater conduction loss.

If an unintended excessive current such as a lightning surge or the like flows, a forward voltage rapidly increases and thus a great loss occurs in the GaN diode. Breakdown resistance is reduced further than that of the silicon diode.

The same problem also occurs in a normally-on type FET which uses GaN whose On-voltage has a positive temperature coefficient.

### BRIEF DESCRIPTION OF THE DRAWINGS

FIG. 1 is a circuit diagram exemplifying a rectifying circuit according to a first embodiment;
FIG. 2 is a characteristic diagram illustrating temperature-dependency of forward voltage-forward current curves of silicon and GaN diodes;
FIG. 3 is a circuit diagram exemplifying a rectifying circuit according to a second embodiment;
FIG. 4 is a characteristic diagram illustrating dependency of a drain current of a normally-on type element on a potential of a control terminal;
FIG. 5 is a cross-sectional view exemplifying a rectifying circuit according to a third embodiment;
FIG. 6 is a cross-sectional view exemplifying a rectifying circuit according to a fourth embodiment;
FIGS. 7A and 7B are circuit diagrams exemplifying a fifth embodiment; and
FIG. 8 is a circuit diagram exemplifying a sixth embodiment.

### DETAILED DESCRIPTION

According to an embodiment, a rectifying circuit includes a first rectifying portion and a second rectifying portion. The first rectifying portion has a positive temperature coefficient. The second rectifying portion has a negative temperature coefficient, is connected in parallel to the first rectifying portion, and has a forward voltage-forward current curve intersecting a forward voltage-forward current curve of the first rectifying portion.

According to another embodiment, there is provided an electronic circuit including a rectifying circuit. The rectifying circuit includes a first rectifying portion and a second rectifying portion. The first rectifying portion has a positive temperature coefficient. The second rectifying portion has a negative temperature coefficient, is connected in parallel to the first rectifying portion, and has a forward voltage-forward current curve intersecting a forward voltage-forward current curve of the first rectifying portion.

According to still another embodiment, there is provided an electronic apparatus including an electronic circuit. The electronic circuit includes a rectifying circuit. The rectifying circuit includes a first rectifying portion and a second rectifying portion. The first rectifying portion has a positive temperature coefficient. The second rectifying portion has a negative temperature coefficient, is connected in parallel to the first rectifying portion, and has a forward voltage-forward current curve intersecting a forward voltage-forward current curve of the first rectifying portion.

Variuos embodiments will be described hereinafter with reference to the accompanying drawings. In the following description, the same constituent elements are given the same reference numerals, and description of a constituent element described once will not be repeated.

### First Embodiment

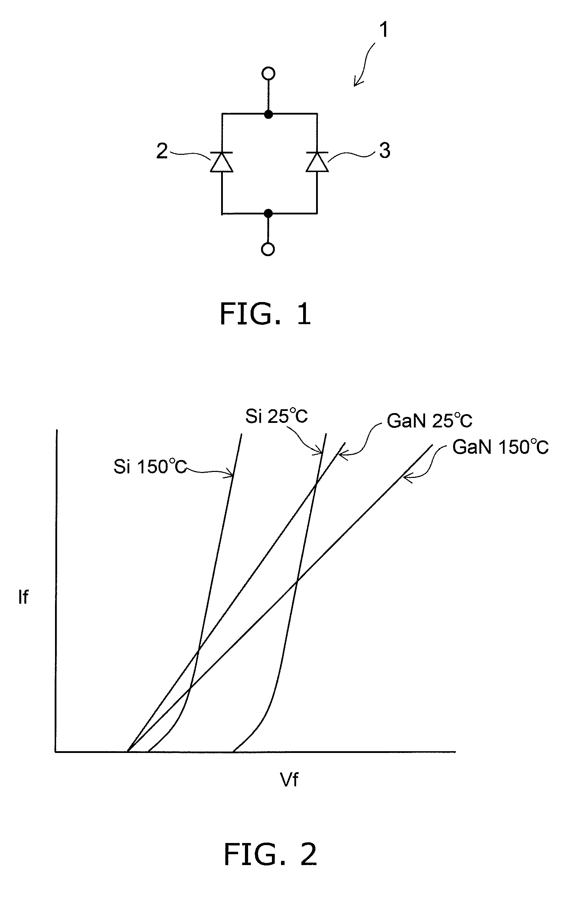

FIG. 1 is a circuit diagram exemplifying a rectifying circuit according to a first embodiment.

A rectifying circuit 1 includes a first rectifying portion 2 and a second rectifying portion 3. The first rectifying portion 2 and the second rectifying portion 3 are connected in parallel to each other.

The first rectifying portion 2 has a positive temperature coefficient. The second rectifying portion 3 has a negative temperature coefficient. Forward voltage-forward current curves thereof intersect each other.

As the rectifying portion having a positive temperature coefficient, a diode which is made of a compound semiconductor or an oxide semiconductor may be used. The compound semiconductor is, for example, gallium nitride (GaN) or silicon carbide (SiC). The oxide semiconductor is, for example, zinc oxide (ZnO). As the rectifying portion having a negative temperature coefficient, for example, a diode (hereinafter, referred to as a silicon diode) made of silicon may be used.

Hereinafter, as an example, a description will be made of a case where a GaN diode is used as the first rectifying portion, and a silicon diode is used as the second rectifying portion. As will be described later, forward voltage-forward current curves of the diodes intersect each other.

FIG. 2 is a characteristic diagram illustrating temperature-dependency of forward voltage-forward current curves of the silicon and GaN diodes.

The transverse axis of FIG. 2 expresses a forward voltage, and the longitudinal axis thereof expresses a forward current. If a temperature increases from 25°C to 150°C, in the GaN diode, a slope of the forward voltage-forward current curve decreases. In other words, an On-resistance increases, and thus a forward voltage increases. In the silicon diode, the forward voltage-forward current curve transitions in a low voltage direction, and thus a forward voltage is reduced.

The GaN diode has a linear forward voltage-forward current curve, whereas the silicon diode has an exponential forward voltage-forward current curve. Even at the same temperature, in a small current region, the GaN diode has a low forward voltage, and, in a large current region, the silicon diode has a low forward voltage. As mentioned above, the forward voltage-forward current curves of both diodes intersect each other.

Therefore, if both diodes are connected in parallel to each other, so as to form the rectifying circuit 1, the diode having a lower forward voltage performs a rectifying operation. In a low temperature region, the GaN diode performs a rectifying operation, and, in a high temperature region, the silicon diode performs a rectifying operation. Meanwhile, in a small current region, the GaN diode performs a rectifying operation, and, in a large current region, the silicon diode performs a rectifying operation. A forward voltage of the rectifying circuit 1 is the same as a lower forward voltage of the GaN diode and the silicon diode.

Effects of the first embodiment will be described.

According to the embodiment, an effect can be achieved in which a loss is reduced since a forward voltage can be reduced in wider ranges of temperature and current than when the GaN diode or the silicon diode is used singly. An effect can also be achieved in which a surge resistance which is equivalent to a surge resistance of the silicon diode is obtained even if surge currents are superimposed.

### Second Embodiment

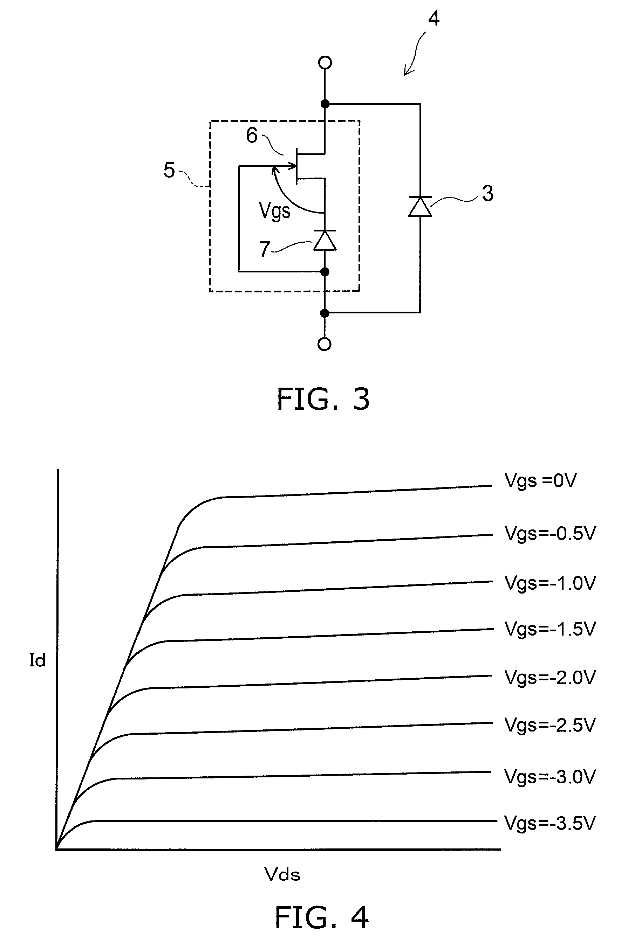

FIG. 3 is a circuit diagram exemplifying a rectifying circuit according to a second embodiment.

A rectifying circuit 4 includes a first rectifying portion 5 and a second rectifying portion 3. The first rectifying portion 5 and the second rectifying portion 3 are connected in parallel to each other.

The first rectifying portion 5 includes a diode 7 and a transistor 6 which is connected in series to a cathode of the diode 7 and has a gate which is a control terminal connected to an anode of the diode 7. The second rectifying portion 3 is a silicon diode.

The transistor 6 is a normally-on type field effect transistor made of a compound semiconductor or an oxide semiconductor, and is, for example, a high electron mobility transistor (HEMT) made of GaN. The diode 7 is, for example, a silicon Schottky barrier diode.

An operation of the first rectifying portion 5 will be described.

When a forward voltage is applied, that is, a positive voltage is applied to the anode side of the diode 7, the diode 7 is turned on, and thus the transistor 6 which is a normally-on type element is also turned on. For this reason, the rectifying portion 5 is turned to an On state. When a backward voltage is applied, that is, a negative voltage is applied to the anode side of the diode 7, the diode 7 is turned off. A gate-source voltage Vgs of the transistor 6 becomes a negative voltage, and thus the transistor 6 is also turned off. Therefore, the rectifying portion 5 is turned to an Off state.

When the backward voltage is applied, a reverse voltage applied to the diode 7 is Vgs of the transistor 6, and thus a low breakdown voltage silicon Schottky barrier diode can be used as the diode 7. Generally, the low breakdown voltage silicon Schottky barrier diode has a low forward voltage, and also has a low forward voltage during turned-on of the transistor 6, and thus a forward voltage of the rectifying portion 5 is lower than that of a single GaN diode.

Characteristics of the transistor 6 will be described with reference to FIG. 4.

FIG. 4 is a characteristic diagram illustrating dependency of a drain current of the normally-on type transistor on a potential of the control terminal. The transverse axis of FIG. 4 expresses a drain-source voltage, and the longitudinal axis expresses a drain current.

As is clear from FIG. 4, if a drain current Id reaches a predetermined current value, an On-resistance of the normally-on type transistor 6 increases. In other words, the normally-on type transistor 6 shows a constant current characteristic. The drain current Id in a state of showing the constant current characteristic depends on a gate-source voltage Vgs. As an absolute value of the gate-source voltage Vgs increases, a value of the drain current Id in the constant current characteristic decreases.

When a forward voltage is applied to the rectifying portion 5, Vgs of the normally-on type transistor 6 becomes a voltage corresponding to a forward voltage of a silicon Schottky barrier diode, for example, 0.2 V. In this case, the drain current Id of the normally-on type transistor 6 in the constant current characteristics is equivalent to the maximal drain current Id in FIG. 4. If a current which is equal to or greater than the maximal current is to be made to flow, a forward voltage rapidly increases.

In addition, since GaN has a positive temperature coefficient, an On-resistance increases even under high temperature circumstances, and thus a forward voltage also increases.

Therefore, if a silicon diode which is the second rectifying portion is connected in parallel so as to form a rectifying circuit, the diode or the rectifying portion having a lower forward voltage performs a rectifying operation. In a low temperature region, the GaN diode performs a rectifying operation, and, in a high temperature region, the silicon diode performs a rectifying operation. Meanwhile, in a small current region, the GaN diode performs a rectifying operation, and, in a large current region, the silicon diode performs a rectifying operation. A forward voltage of the rectifying circuit 1 is the same as a lower forward voltage of the GaN diode and the silicon diode.

Effects of the second embodiment will be described.

An effect can be achieved in which a loss is reduced since a forward voltage can be reduced in wider ranges of temperature and current than when the rectifying portion 5 including the normally-on type field effect transistor made of a compound semiconductor or an oxide semiconductor and the silicon Schottky barrier diode is used singly. In the same manner as in the rectifying circuit according to the first embodiment, an effect can also be achieved in which a surge resistance which is equivalent to a surge resistance of the silicon diode is obtained.

### Third Embodiment

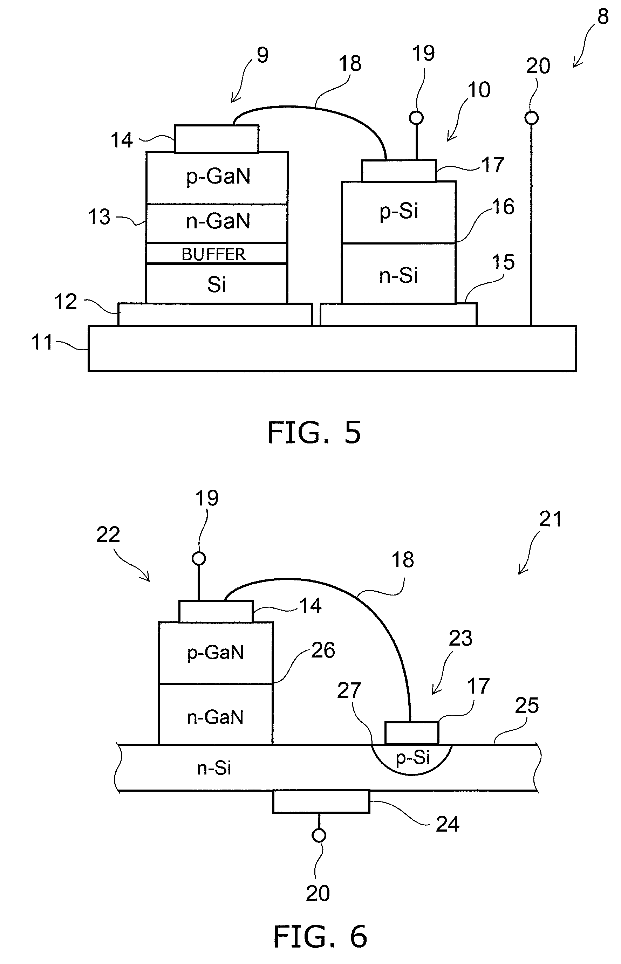

The GaN diode and the silicon diode of the rectifying circuit illustrated in FIG. 1 may be mounted in the same package. A cross-sectional view of the rectifying circuit in this case is illustrated in FIG. 5.

FIG. 5 is a cross-sectional view exemplifying a rectifying circuit according to a third embodiment.

A rectifying circuit 8 includes a GaN diode 9 and a silicon diode 10. The GaN diode 9 and the silicon diode 10 are mounted on a metal support substrate 11. The GaN diode 9 includes a cathode electrode 12, a semiconductor substrate 13, and an anode electrode 14. The semiconductor substrate 13 has a silicon substrate, a buffer layer, an n type GaN semiconductor, and a p type GaN semiconductor. The silicon diode 10 includes a cathode electrode 15, a semiconductor substrate 16, and an anode electrode 17. The semiconductor substrate 16 has an n type silicon semiconductor and a p type silicon semiconductor.

The anode electrode 14 is connected to the anode electrode 17 via a connection conductor 18. A terminal 19 is connected to the anode electrode 14 or 17, and a terminal 20 is connected to the metal support substrate 11.

Effects of the third embodiment will be described.

According to the present embodiment, an effect can be achieved in which a loss is reduced since a forward voltage can be reduced in wider ranges of temperature and current than when the GaN diode or the silicon diode is used singly. An effect can also be achieved in which a surge resistance which is equivalent to a surge resistance of the silicon diode is obtained even if surge currents are superimposed. The GaN diode and the silicon diode are mounted on the same metal support substrate so as to produce a single package, and thus an effect of miniaturizing the rectifying circuit can also be achieved.

### Fourth Embodiment

The GaN diode and the silicon diode of the rectifying circuit illustrated in FIG. 1 may be formed using a monolithic semiconductor structure. A cross-section of a rectifying circuit in this case illustrated in FIG. 6.

FIG. 6 is a schematic cross-sectional view exemplifying a rectifying circuit according to a fourth embodiment.

A rectifying circuit 21 includes a GaN diode 22 and a silicon diode 23. The GaN diode 22 has a semiconductor substrate 26 and an anode electrode 14. The semiconductor substrate 26 includes an n type GaN semiconductor and a p type GaN semiconductor. The silicon diode 23 has a diode region 27 which is provided inside a silicon substrate 25 as a diffusion layer, and an anode electrode 17. The diode region 27 includes an n type silicon semiconductor and a p type silicon semiconductor. A cathode electrode 24 is shared by the GaN diode 22 and the silicon diode 23, and is provided on a rear surface of the silicon substrate 25. In addition, the silicon substrate 25 may be a growth substrate which crystal-grows the GaN diode 22, or may be a support substrate obtained by appropriately removing a growth substrate on which a laminate structure of the GaN diode 22 is grown and by joining the laminate structure to a substrate. Effects of the fourth embodiment will be described.

According to the present embodiment, an effect can be achieved in which a loss is reduced since a forward voltage can be reduced in wider ranges of temperature and current than when the GaN diode or the silicon diode is used singly. An effect can also be achieved in which a surge resistance which is equivalent to a surge resistance of the silicon diode is obtained even if surge currents are superimposed. The GaN diode and the silicon diode are formed as a single package by using a monolithic semiconductor structure, and thus an effect of miniaturizing the rectifying circuit can also be achieved.

### Fifth Embodiment

Next, a description will be made of an electronic circuit provided with the rectifying circuit according to the present embodiment.

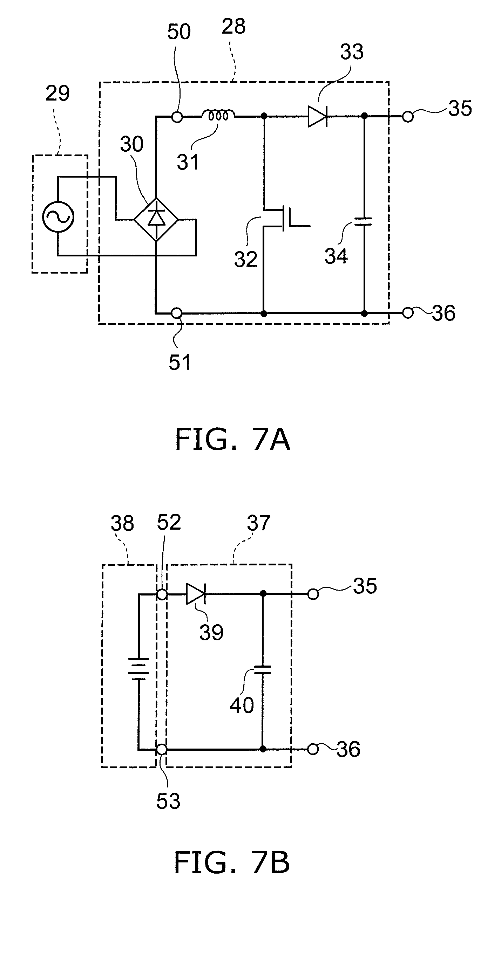

FIGS. 7A and 7B are circuit diagrams respectively exemplifying electronic circuits according to the fifth embodiment.

An electronic circuit 28 illustrated in FIG. 7A includes a bridge rectifier 30, an inductor 31, a switching element 32, a rectifying element 33, a capacitor 34, and a control circuit (not illustrated). The switching element 32 is, for example, a metal-oxide-semiconductor field effect transistor (MOSFET). At least one of respective diodes forming the bridge rectifier 30 and the rectifying element 33 is the rectifying circuit according to the embodiments.

An AC power supply line 29 is connected to an input of the bridge rectifier 30. One end of the inductor 31 is connected to a high potential output terminal 50 of the bridge rectifier 30, and the other end of the inductor 31 is connected to a drain of the switching element 32. A source of the switching element 32 is connected to a low potential output terminal 51 of the bridge rectifier 30. An anode of the rectifying element 33 is connected to the drain of the switching element 32, and a cathode of the rectifying element 33 is connected to one end of the capacitor 34. The other end of the capacitor 34 is connected to the low potential output terminal 51 of the bridge rectifier 30.

The electronic circuit 28 is a circuit which boosts a voltage by rectifying an AC voltage from the AC power supply line 29 and turning on and off the switching element 32.

An electronic circuit 37 illustrated in FIG. 7B includes a rectifying element 39 and a capacitor 40. The rectifying element 39 is a rectifying circuit according to the embodiments.

An anode of the rectifying element 39 is connected to a high potential terminal 52 of a DC power supply line 38, and a cathode of the rectifying element 39 is connected to one end of the capacitor 40. The other end of the capacitor 40 is connected to a low potential terminal 53 of the DC power supply line 38. The rectifying circuit according to the embodiments is applied to the rectifying element 39.

The electronic circuit 37 operates as a reverse connection protecting circuit of the DC power supply line.

Effects of the fifth embodiment will be described.

According to the embodiment, by employing the rectifying circuit according to the embodiments, an effect can be achieved in which a loss of the electronic circuit is reduced in wide ranges of temperature and current. Even if surge currents are superimposed, a surge resistance which is equivalent to a surge resistance of the silicon diode is obtained, and thus an effect can also be achieved in which an electronic circuit with higher reliability can be provided than when the GaN diode is used.

### Sixth Embodiment

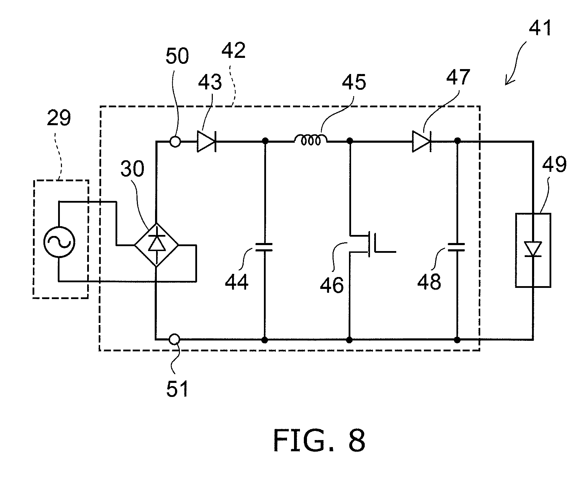

FIG. 8 is a circuit diagram exemplifying a sixth embodiment.

An electronic apparatus 41 illustrated in FIG. 8 includes an electronic circuit 42 and a lighting load 49. The lighting load 49 has a lighting light source such as, for example, a light emitting diode (LED).

The electronic circuit 42 includes a bridge rectifier 30, a rectifying element 43, a capacitor 44, an inductor 45, a switching element 46, a rectifying element 47, and a capacitor 48. The switching element 46 is, for example, a MOSFET. At least one of respective diodes forming the bridge rectifier 30 and the rectifying elements 43 and 47 is the rectifying circuit according to the embodiments.

An AC power supply line 29 is connected to an input of the bridge rectifier 30. An anode of the rectifying element 43 is connected to a high potential output terminal 50 of the bridge rectifier 30, and a cathode of the rectifying element 43 is connected to one end of the capacitor 44. The other end of the capacitor 44 is connected to a low potential output terminal 51 of the bridge rectifier 30. One end of the inductor 45 is connected to the cathode of the rectifying element 43, and the other end of the inductor 45 is connected to a drain of the switching element 46. A source of the switching element 46 is connected to the low potential output terminal 51 of the bridge rectifier 30. An anode of the rectifying element 47 is connected to one end of the capacitor 48, and the other end of the capacitor 48 is connected to the low potential output terminal 51 of the bridge rectifier 30. The lighting load 49 is connected in parallel to the capacitor 48.

The electronic apparatus 41 is a lighting apparatus which rectifies and drops an AC voltage from the AC power supply line 29 and supplies the dropped voltage to the lighting load 49. In this lighting apparatus, there is a probability that power consumption widely varies from turning-off thereof to complete turning-on thereof. For this reason, a magnitude of an input current also widely fluctuates. Since the lighting apparatus is connected to the AC power supply line, the lighting apparatus is required to have resistance to a surge current such as a lightning surge. By employing the rectifying circuit according to the embodiments, an effect can be achieved in which a loss is reduced in wide ranges of temperature and current since a forward voltage of the rectifying element can be reduced. Even if surge currents are superimposed, a surge resistance which is equivalent to a surge resistance in a case of using the silicon diode is obtained.

Effects of the sixth embodiment will be described.

According to the present embodiment, by employing the rectifying circuit according to the embodiments, an effect can be achieved in which a loss of an electronic apparatus is reduced. Since the rectifying circuit according to the embodiment obtains a surge resistance which is equivalent to a surge resistance of the silicon diode, an effect can also be achieved in which an electronic apparatus with high reliability can be provided.

As mentioned above, the embodiments are described with reference to specific examples, but are not limited thereto and may have various modifications.

For example, the first and second rectifying portions are not limited to GaN. For example, a semiconductor element may be used which is formed on a semiconductor substrate by using a semiconductor (wide band gap semiconductor) having a wide band gap, such as, for example, silicon carbide (SiC), gallium nitride (GaN), or diamond. Here, the wide band gap semiconductor refers to a semiconductor having a wider band gap than that of gallium arsenide (GaAs), whose band gap is about 1.4 eV. The semiconductor includes semiconductors whose band gap is 1.5 eV or greater, for example, gallium phosphide (GaP whose band gap is about 2.3 eV), gallium nitride (GaN whose band gap is about 3.4 eV), diamond (C whose band gap is about 5.27 eV), aluminum nitride (AIN whose band gap is about 5.9 eV), silicon carbide (SiC), and the like.

In addition, the lighting load is not limited to an LED, and may be, for example, an organic electroluminescence (OEL) element, an organic light emitting diode (OLED), or the like.

As mentioned above, the embodiments are described with reference to the specific examples. However, the embodiments are not limited to the specific examples. In other words, ones obtained by those skilled in the art adding an appropriate design modification to the specific examples are included in an embodiment as long as they have features of the embodiment. The constituent elements of each of the above-described specific examples, the arrangements, the materials, the conditions, the shapes, the sizes, and the like thereof are not limited to the exemplified ones, and may be appropriately changed.

In addition, the respective constituent elements of each of the above-described embodiments may be combined with each other as long as the combination is technically possible, and the combination is also included in an embodiment as long as the combination includes features of the embodiment. Further, those skilled in the art can conceive of various changes and alterations in the scope of the spirit of the embodiments, and it is understood that the changes and alterations are included in the embodiments.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A rectifying circuit (1, 4, 8, 21) comprising:
a first rectifying portion (2, 5) having a positive temperature coefficient; and
a second rectifying portion (3) having a negative temperature coefficient, connected in parallel to the first rectifying portion (2, 5), and having a forward voltage-forward current curve intersecting a forward voltage-forward current curve of the first rectifying portion (2, 5).

2. The circuit (1, 8, 21) according to claim 1, wherein the first rectifying portion (2) is a compound semiconductor diode or an oxide semiconductor diode, and
the second rectifying portion (3) is a silicon diode.

3. The circuit (4) according to claim 1, wherein the first rectifying portion (5) includes
a diode, and
a normally-on type field effect transistor connected in series to a cathode of the diode, having a control terminal connected to an anode of the diode, and made of a compound semiconductor or an oxide semiconductor, and
the second rectifying portion is a silicon diode.

4. An electronic circuit (28, 37, 42) comprising: the rectifying circuit (1, 4, 8, 21) according to any one of claims 1 to 3.

5. An electronic apparatus (41) comprising: the electronic circuit (28, 37, 42) according to claim 4.
